Europäisches Patentamt

European Patent Office

Office européen des brevets

(11) Veröffentlichungsnummer: **0 021 428**
**B1**

(12) **EUROPÄISCHE PATENTSCHRIFT**

(45) Veröffentlichungstag der Patentschrift:
02.11.83

(51) Int. Cl.³: **G 03 F 7/08, G 03 C 1/76**

(21) Anmeldenummer: **80103610.4**

(22) Anmeldetag: **26.06.80**

(54) **Lichtempfindliches, positiv arbeitendes Kopiermaterial mit rauher Oberfläche.**

(30) Priorität: **29.06.79 DE 2926236**

(43) Veröffentlichungstag der Anmeldung:
**07.01.81 Patentblatt 81/1**

(45) Bekanntmachung des Hinweises auf die Patenterteilung:
**02.11.83 Patentblatt 83/44**

(84) Benannte Vertragsstaaten:
**AT BE CH DE FR GB IT LI NL SE**

(56) Entgegenhaltungen:
**CH - A - 330 158
DE - A - 1 813 447
DE - C - 447 178
FR - A - 873 675
FR - A - 927 470
FR - A - 2 025 640
FR - A - 2 308 128
GB - A - 2 025 646
GB - A - 2 030 309
US - A - 3 615 468
US - A - 3 829 315**

**RESEARCH DISCLOSURE, Nr. 180, April 1979, Seiten 160-161 Homewell, Havant Hampshire, G.B. "A light-sensitive material having a matting layer"**

(73) Patentinhaber: **HOECHST AKTIENGESELLSCHAFT,
Postfach 80 03 20, D-6230 Frankfurt am Main 80 (DE)**

(72) Erfinder: **Stahlhofen, Paul, Dr.,
Walter-Gieseking-Strasse 28, D-6200 Wiesbaden (DE)**

## Lichtempfindliches, positiv arbeitendes Kopiermaterial mit rauher Oberfläche

Die Erfindung betrifft eine lichtempfindliche Druckplatte mit einem Schichtträger und einer positiv arbeitenden lichtempfindlichen Schicht mit rauher Oberfläche, die bevorzugt zur Herstellung von Flachdruckformen geeignet ist.

Aus der DE-A-2 403 487 sind Hochdruckplatten mit einer matten Oberfläche bekannt, die durch Prägen der Oberfläche der lichtempfindlichen Schicht mit einem Prägeelement bestimmter Oberflächenrauhigkeit, z.B. einer aufgerauhten Metalloberfläche, erzeugt wird. Diese Platte hat den Vorteil, dass sie beim Kopieren im Vakuumkopierrahmen rasch mit einer glatten Kopiervorlage in engen Kontakt gebracht werden kann, ohne dass beim Evakuieren Lufteinschlüsse gebildet werden. Die mattierte Oberfläche weist ferner eine bessere Farbannahme beim Drucken auf. Die lichtempfindliche Schicht kann Pigmente oder Füllstoffe enthalten, um die Mattierung zu unterstützen. Da die Schicht relativ, d.h. etwa 0,075 bis 6,25 mm dick ist, ist die Teilchengrösse der dort verwendeten Pigmente bzw. Füllstoffe stets wesentlich kleiner als die Schichtdicke, so dass diese zwar eine optische Mattierung bewirken, aber auf die Oberflächenrauhigkeit praktisch keinen Einfluss haben.

Für den gleichen Zweck sind in den DE-A-2 512 043, 2 533 156, 2 606 793 und 2 638 710 vorsensibilisierte Druckplatten beschrieben, die entweder aufgerauhte oder diskontinuierliche nichtlichtempfindliche Deckschichten aufweisen oder deren lichtempfindliche Schicht eine rauhe, durch Anwendung einer rauhen Beschichtungswalze erzeugte Oberfläche aufweist. Die Erzeugung einer aufgerauhten Deckschicht erfolgt u.a. durch Zusatz eines Mattierungsmittels, z.B. eines Pigments, in relativ grosser Menge. In der DE-A-2 533 156, Seite 3, erster Absatz, wird jedoch darauf hingewiesen, dass das Einbringen einer relativ grossen Menge Mattierungsmittel Nachteile hat.

Die Anwendung von Beschichtungswalzen mit rauher Oberfläche ist technologisch schwieriger als die von glatten Walzen, da hier stets die Einhaltung einer gleichmässigen Oberflächenrauhigkeit kontrolliert werden muss. Das Aufbringen einer zusätzlichen mattierten Deckschicht ist als zusätzlicher Arbeitsgang ebenfalls technologisch aufwendig. Es hat sich weiterhin gezeigt, dass bei Anwendung von Deckschichten, die relativ grosse Pigmentpartikel enthalten und selbst eine gewisse Schichtdicke haben, oder von diskontinuierlichen Deckschichten infolge des örtlich vergrösserten Abstands zwischen Vorlage und lichtempfindlicher Schicht eine Neigung zu Unterstrahlungen und damit zur ungenauen Abbildung von kleinen Bildelementen, z.B. Rasterpunkten, besteht.

Hierdurch wird ferner die sogenannte Lichtkorrektur, d.h. das Wegbelichten von Filmkanten, bei Druckplatten mit positiv arbeitenden Kopierschichten stark erschwert. In der Praxis ist bei Verwendung der oben genannten Druckplatten eine Lichtkorrektur im allgemeinen nicht durchführbar, weil durch die hierfür notwendige längere Belichtungszeit starke Verluste bei den feinen, spitzen Rastertonwerten, den sogenannten Spitzlichtern, auftreten. Ein tonwertrichtiges Kopierergebnis ist deshalb nicht möglich. Wird auf die Lichtkorrektur verzichtet, dann bedeutet dies anderseits, dass für eine filmkantenfreie Platte Mehraufwand in Form von Korrekturarbeit oder Deckmontagen erforderlich ist.

Die CH-A-330 158 beschreibt ein photographisches Silberhalogenidmaterial, das zur Vermeidung eines zu engen Kontakts bei der Lagerung oder beim Kopieren eine rauhe Oberfläche aufweist, die durch Einverleiben von feinteiligen Partikeln erzeugt wird. Die Verarbeitung des Materials erfolgt durch Belichten, Entwickeln und Fixieren, wobei gegebenenfalls die Partikel wieder aus der Oberflächenschicht herausgewaschen werden. Derartige gerauhte Silberfilme werden als Kopiervorlagen verwendet. Hier hat die Filmoberfläche nach der Bildherstellung keine wesentliche Funktion zu erfüllen.

Gemäss der US-A-3 615 468 wird ebenfalls die Oberfläche der Kopiervorlage durch Einbetten von Partikeln gerauht. Hier dient die lichtempfindliche Schicht ähnlich wie bei der CH-A- zur Erzeugung eines Bilds mit visuell erkennbaren Kontrasten. Es erfolgt kein Auswaschen von belichteten oder unbelichteten Schichtbereichen zum Reliefbild, wie es bei einer Druckplatte der Fall ist.

Die Lösung, dass die Oberfläche der Kopiervorlage statt der Druckplatte rauh gemacht wird, hat den Nachteil, dass die ohnehin sehr teure und aufwendige Herstellung von reprographischen Rastervorlagen weiter verteuert wird.

Aufgabe der Erfindung war es, eine lichtempfindliche Druckplatte zu schaffen, die die Vorteile der bekannten Druckplatten mit rauher Oberfläche aufweist, aber einfacher herzustellen ist und beim Kopieren geringere Neigung zu Unterstrahlungen hat.

Die Erfindung geht aus von einer lichtempfindlichen Druckplatte mit einem Schichtträger aus Aluminium und einer positiv arbeitenden lichtempfindlichen Schicht mit rauher Oberfläche und einem Gehalt an feinteiligen Partikeln, wobei die Schicht als lichtempfindliche Substanz ein 1,2-Naphthochinondiazid oder ein Gemisch einer bei Belichtung eine starke Säure bildenden Verbindung mit einer Verbindung, die mindestens eine durch Säure spaltbare C–O–C-Bindung aufweist, sowie ferner ein wasserunlösliches, in organischen Lösungsmitteln und in verdünnten wässrigalkalischen Lösungen lösliches Harz enthält.

Die erfindungsgemässe Druckplatte ist dadurch gekennzeichnet, dass die kleinste Abmessung der Partikel mindestens so gross ist wie die Dicke der Schicht, dass der mittlere Durchmesser der Partikel zwischen 1 und 20 µm liegt und dass die lichtempfindliche Schicht 0,02 bis 2,0 Gew.-% Partikel enthält. Vorzugsweise sind die Partikel grösser als die Schichtdicke, so dass die Schichtoberfläche eine zu einem wesentlichen Teil durch die Differenz von Partikelgrösse und Schichtdicke bestimmte Rauhigkeit erhält. Der mittlere Durchmesser der Partikel ist deshalb bevorzug 1 bis 15 µm grösser als die Schichtdicke, so dass die Schichtoberfläche eine mittlere Oberflächenrauhigkeit aufweist, die auch ungefähr in diesem Bereich liegt.

Die Schichtdicke der Kopierschicht richtet sich nach dem Verwendungszweck des Materials und entspricht den sonst üblichen Werten. Bei der bevorzugten Anwendung des Materials zur Herstellung von Flachdruckformen liegt sie im allgemeinen zwischen 0,1 und 5, vorzugsweise zwischen 1 und 4 µm.

Die mittlere Teilchengrösse der in die Kopierschicht eingelagerten Partikel liegt bei Flachdruckplatten im allgemeinen zwischen 1 und 20, vorzugsweise zwischen 3 und 10 µm. Der Partikelanteil in der Kopierschicht liegt zwischen 0,02 und 2,0 Gew.-%, vorzugsweise zwischen 0,1 und 1,0 Gew.-%, bezogen auf den Gesamtgehalt der Kopierschicht an nichtflüchtigen Bestandteilen.

Als Partikel, die gemäss der Erfindung in die lichtempfindliche Kopierschicht eingelagert werden, können solche Substanzen verwendet werden, die mit der Kopierschicht verträglich sind, die Beschichtung des Trägers nicht nachteilig beeinflussen und zusammen mit den belichteten Bereichen der lichtempfindlichen Positiv-Schicht mit Hilfe eines Entwicklers wieder entfernt werden können, ohne mit diesem zu reagieren.

Bevorzugte Beispiele für derartige Partikel sind Teilchen aus Kieselsäure oder Siliciumdioxid, die speziell vorbehandelt sein können, aus Aluminiumoxid, Zinkoxid, Aluminiumsilikat, Aluminiumhydroxid, Titandioxid oder in den zur Beschichtung verwendeten Lösungsmitteln unlöslichen organischen polymeren Verbindungen. Die Partikel können jeweils aus einer Substanz bestehen, oder es können Partikel aus verschiedenen Substanzen kombiniert werden.

Zur Herstellung der Kopierschichten werden die Teilchen unter gutem Rühren direkt zur Beschichtungslösung gegeben oder vorteilhafter in einer Kugelmühle zusammen mit einem Teil des Harzes oder Binders, der ohnehin für die Kopierschicht verwendet wird, in einem geeigneten Lösungsmittel dispergiert. Diese Dispersion wird dann dem Rest der vorgesehenen Beschichtungslösung unter gutem Rühren zugefügt.

Als lichtempfindliche Substanzen enthalten die Kopierschichten 1,2-Naphthochinondiazide, insbesondere die Naphthochinon-(1,2)-diazid-(2)-sulfonsäureester oder -amide, oder Gemische von säurespaltbaren Verbindungen mit photolytischen Säurespendern. Als säurespaltbare Verbindungen sind Derivate von Orthocarbonsäuren, insbesondere Orthocarbonsäureester und Carbonsäureamidacetale, sowie Acetale und N,O-Acetale geeignet. Derartige positiv arbeitende Gemische sind z.B. in den US-PS 3 779 778 und 4 101 323 und der DE-OS 2 718 254 beschrieben. Die lichtempfindlichen Schichten enthalten ferner alkalilösliche Harze, z.B. Phenolharze, Acryl- oder Methacrylsäuremischpolymerisate, Maleinsäuremischpolymerisate und andere Carboxylgruppen enthaltende Polymerisate. Bevorzugt werden Phenolharze, insbesondere Novolake.

Weitere mögliche Schichtbestandteile sind kleinere Mengen, d.h. bis zu etwa 20 Gew.-% der Schicht, alkaliunlöslicher Harze, Farbstoffe, Weichmacher, Haftverbesserungsmittel und anderer üblicher Zusätze.

Die Auswahl der geeigneten Träger erfolgt nach Massgabe der Art der Druckplatte. Im allgemeinen wird Aluminium verwendet, das bevorzugt eine anodisch erzeugte poröse Oxidschicht trägt. Das Aluminium wird zweckmässig vor dem Anodisieren mechanisch, chemisch oder elektrolytisch aufgerauht. Die Anodisierung erfolgt in bekannter Weise, z.B. in Schwefel- und/oder Phosphorsäure, vorzugsweise unter solchen Bedingungen, dass eine Oxidschicht mit einem Schichtgewicht von etwa 0,5 bis 10 g/m² erhalten wird.

Vorteilhaft wird die Oxidschicht vor dem Aufbringen der lichtempfindlichen Schicht einer Vorbehandlung zur Verbesserung des drucktechnischen Verhaltens, insbesondere der Hydrophilie, unterworfen, z.B. mit Silikaten oder Polyvinylphosphonsäure. Die Beschichtung des Trägermaterials erfolgt in bekannter Weise durch Aufschleudern, Sprühen, Tauchen, mittels Walzen, Schlitzdüsen, Rakeln oder durch Giesser-Antrag.

Es ist vorteilhaft, die Streichlösung während des Beschichtungsvorganges durch ständiges Rühren in Bewegung zu halten. Ferner können der Streichlösung zwecks besserer Benetzung gegebenenfalls Netz- oder Verlaufmittel zugesetzt werden.

Zur Entwicklung wird die belichtete Druckplatte mit einer geeigneten Entwicklerlösung, bevorzugt einer schwach alkalischen wässrigen Lösung behandelt, wobei die vom Licht getroffenen Anteile der Schicht entfernt werden und die unbelichteten Bereiche der Kopierschicht einschliesslich der in die Schicht eingelagerten Pigmente auf dem Träger zurückbleiben.

Von der so hergestellten Druckform können Druck mit sehr hoher Auflage hergestellt werden.

Mit Hilfe der erfindungsgemäss hergestellten pigmenthaltigen Kopierschicht und eines geeigneten Schichtträgers wird ein Kopiermaterial mit einer rauhen oder unebenen Schichtoberfläche erhalten, mit der es möglich wird, ein Diapositiv in innigen Kontakt mit der lichtempfindlichen Schicht zu bringen, wobei die für das Entlüften des Vakuumkopierrahmens notwendige Zeit erheblich vermindert wird. Dieser Vorteil wird erreicht, ohne dass es aufgrund von zurückbleibenden Lufteinschlüssen zwischen Schichtoberfläche und Kopiervorlage zu Unterstrahlungen kommt. Das erfindungsgemässe Material lässt sich wesentlich einfacher herstellen als bisher für den gleichen Zweck bekannte Materialien. Es ist nur eine Beschichtung unter üblichen Bedingungen erforderlich, und die Schichtoberfläche bedarf keiner nachträglichen Bearbeitung, z.B. einer Prägung.

Gegenüber den mit einer unebenen mattierungsmittelhaltigen lichtunempfindlichen Deckschicht versehenen Kopierschichten oder gegenüber Druckplatten, die auf der lichtempfindlichen Kopierschicht zusätzlich ein unebenes regelmässiges Muster haben, besitzen die erfindungsgemäss hergestellten Druckplatten einen wesentlich grösseren Belichtungsspielraum, ohne dass es infolge von Unterstrahlungen zu Rasterpunktverkleinerungen kommt.

Das erfindungsgemässe Kopiermaterial wird, wie bereits erwähnt, vorzugsweise zur Herstellung von Flachdruckformen verwendet. Es ist jedoch grundsätzlich für alle Anwendungen geeignet, bei denen positive Kontaktkopien in einem Vakuumkopierrahmen gemacht werden und bei denen es auf hohe Bildauflösung und getreue Wiedergabe der Vorlage ankommt, also insbesondere bei feinen Strich- und Rastervorlagen. Weitere Anwendungsformen sind deshalb die Herstellung von Ätzdruckformen, z.B. Mehrmetall- und Tiefdruckformen, sowie von Photoresists als Ätz- oder Galvanoreservagen, z.B. bei der Herstellung gedruckter Schaltungen.

Die Erfindung wird an Hand der nachfolgenden Beispiele näher erläutert, in denen Gewichtsteile (Gt) und Volumteile (Vt) im Verhältnis von g zu ccm stehen. Prozente sind, wenn nichts anderes angegeben ist, Gewichtsprozente.

Beispiel 1

Dispersion A:
Man löst
30,0 Gt eines Kresol-Formaldehyd-Novolaks mit einem Erweichungspunkt von 105–120°C in
100,0 GT Äthylenglykolmonomethyläther.
In die filtrierte Lösung gibt man
0,28 Gt einer oberflächenbehandelten Kieselsäure mit einer Teilchengrösse von 4 μm (Mittelwert).
Diese Mischung wird ca. 15 Minuten mit Hilfe eines Schnellrührers in heftiger Bewegung gehalten.

Lösung B:
Man löst
8,50 Gt des Veresterungsproduktes aus 1 Mol 2,3,4-Trihydroxy-benzophenon und 3 Mol Naphthochinon-(1,2)-diazid-(2)-5-sulfonsäurechlorid,
6,60 Gt des Veresterungsproduktes aus 1 Mol 2,2'-Dihydroxy-dinaphthyl-(1,1')-methan und 2 Mol Naphthochinon-(1,2)-diazid-(2)-5-sulfonsäurechlorid,
2,10 Gt Naphthochinon-(1,2)-diazid-(2)-4-sulfonsäurechlorid,
35,00 Gt des oben angegebenen Kresol-Formaldehyd-Novolaks und
0,75 Gt Kristallviolett (C.I. 42 555)
in einem Lösungsmittelgemisch aus
260 Gt Äthylenglykolmonomethyläther,
470 Gt Tetrahydrofuran und
80 Gt Butylacetat.

In die filtrierte Lösung B wird unter gutem Rühren die Dispersion A gegeben.

Mit dieser Streichlösung beschichtet man ein elektrolytisch aufgerauhtes und anodisiertes Aluminiumband mittels einer Schlitzdüse, wobei ein Schichtgewicht von ca. 2,0 g/m² erhalten wurde. Das Schichtgewicht in den Beispielen 1–5 in g/m² entspricht etwa der Dicke der lichtempfindlichen Schicht in μm.

Zur Herstellung einer Druckform wird die so erhaltene Druckplatte unter einer transparenten Positiv-Vorlage bildmässig belichtet und anschliessend in bekannter Weise mit der folgenden Lösung entwickelt:

5,3 Gt Natriummetasilikat · 9 Wasser,
3,4 Gt Trinatriumphosphat · 12 Wasser und
0,3 Gt Natriumdihydrogenphosphat (wasserfrei) in
91,0 Gt Wasser.

Durch die Entwicklung werden die vom Licht getroffenen Anteile der Kopierschicht entfernt, und es bleiben die unbelichteten Bildstellen auf dem Schichtträger zurück, wobei man die der Vorlage entsprechende (positive) Druckschablone erhält. Von der so hergestellten Druckform können in einer Offsetmaschine etwa 200 000 einwandfreie Drucke hergestellt werden.

Während die nach Beispiel 1 hergestellte Druckplatte im Kopierrahmen bereits nach 20 Sekunden Absaugzeit (ohne Vorvakuum) in vollständige Berührung mit der Kopiervorlage gebracht werden konnte, ohne dass nach dem Belichten Unterstrahlungserscheinungen auftraten, gelang es mit einer entsprechenden Vergleichsplatte mit gleicher Kopierschicht, jedoch ohne Pigmentzusatz, erst nach 60 Sekunden Absaugzeit für das Vorvakuum und weiteren 60 Sekunden für das Nachvakuum, diese Druckplatte in innige Berührung mit der Filmvorlage zu bringen.

Wenn man Druckplatten von 1270 × 1035 mm Grösse mit einer ebenso grossen transparenten Kopiervorlage mit 50%iger Rasterfläche (60er Raster) im Kopierrahmen montiert und nach einer Mindestabsaugzeit, z.B. 20 Sekunden für 0 bis 85% Vakuum, die hierbei resultierenden Kopien vergleicht, erhält man die folgenden Ergebnisse:

Während die Rasterflächen der Kopiervorlage bei der nach Beispiel 1 hergestellten Druckplatte während der Belichtung einwandfrei übertragen werden, zeigen sich bei der gleichen Kopierschicht, jedoch ohne Pigmentzusatz, Unterstrahlungserscheinungen in Form von Aufhellungen in der Rasterfläche infolge spitzer (kleiner) gewordener oder völlig verlorengegangener Rasterpunkte.

In den folgenden Beispielen 2 bis 5 wird in entsprechender Weise wie im obigen Beispiel 1 verfahren, und es werden beim Kopieren im wesentlichen entsprechende Resultate erhalten. Es werden daher für die folgenden Beispiele meist nur die Rezepturen der Beschichtungslösungen und die Art der verwendeten Schichtträger angegeben und nur gelegentlich weitere kurze Bemerkungen hinzugefügt.

Beispiel 2
Dispersion A:
Man löst

30,0 Gt des in Beispiel 1 angegebenen Kresol-
Formaldehyd-Novolaks in
100,0 Gt Äthylenglykolmonomethyläther.
Nach der Filtration gibt man hierzu
0,20 Gt Aluminiumoxid mit einer mittleren Teilchengrösse von 5 µm.

Diese Mischung wird mit Hilfe eines Schnellrühres ca. 20 Minuten in heftiger Bewegung gehalten.

Lösung B:
Man löst

10,0 Gt 4-(α,α-Dimethyl-benzyl)-phenylester
der Naphthochinon-(1,2)-diazid-(2)-4-
sulfonsäure,
5,60 Gt des Veresterungsproduktes aus 1 Mol
2,2'-Dihydroxy-dinaphthyl-(1,1')-methan
und 2 Mol Naphthochinon-(1,2)-diazid-
(2)-5-sulfonsäurechlorid,
2,40 Gt Naphthochinon-(1,2)-diazid-(2)-4-sulfon-
säurechlorid,
36,00 Gt eines Kresol-Formaldehyd-Novolaks
mit einem Erweichungspunkt von
105–120°C und
0,75 Gt Kristallviolett-Base (C.I. 42 555 : 1)
in einem Lösungsmittelgemisch aus
200 Gt Äthylenglykolmonomethyläther,
500 Gt Tetrahydrofuran und
75 Gt Butylacetat.

In die filtrierte Lösung B wird unter gutem Rühren die Dispersion A gegeben.

Mit dieser Streichlösung beschichtet man ein
elektrochemisch aufgerauhtes und anodisiertes
Aluminiumband mit Hilfe einer Schlitzdüse, wobei
ein Schichtgewicht von 2,8 g/m² erhalten wird.

Beispiel 3

Man dispergiert in einer Kugelmühle von 500 ml
Inhalt mit Hilfe von 150 g Porzellankugeln (Durchmesser ca. 1,5 cm)

0,30 Gt Siliciumdioxid von hoher Reinheit und
einer mittleren Teilchengrösse von ca.
15 µm und
30,0 Gt des in Beispiel 1 angegebenen Kresol-
Formaldehyd-Novolaks in
150,0 Gt Äthylenglykolmonomethyläther.

Nach 4stündiger Mahldauer gibt man diese Dispersion unter gutem Rühren in eine Lösung, die
wie folgt angesetzt und dann filtriert wird:
Man löst

14,0 Gt des Veresterungsproduktes aus 1 Mol
2,4-Dihydroxy-3,5-dibrom-benzophenon
und 2 Mol Naphthochinon-(1,2)-diazid-
(2)-5-sulfonsäurechlorid,
32,0 Gt des in Beispiel 1 angegebenen Kresol-
Formaldehyd-Novolaks,
0,5 Gt Kristallviolett und
0,3 Gt Sudangelb GGN (C.I. 11 021)
in einem Lösungsmittelgemisch aus
200 Gt Äthylenglykolmonomethyläther und
450 Gt Tetrahydrofuran.

Mit dieser Streichlösung beschichtet man mit
Hilfe einer Schlitzdüse ein elektrolytisch aufgerauhtes und anodisiertes Aluminiumband. Hierbei
wird ein Schichtgewicht von 3,30 g/m² erhalten.

Beispiel 4
Dispersion A:
Man löst

30,0 Gt des in Beispiel 1 angegebenen Kresol-
Formaldehyd-Novolaks in
150,0 Gt Äthylenglykolmonomethyläther.
Nach der Filtration fügt man hierzu
0,25 Gt Polyvinylalkohol (Verseifungsgrad
88%, Viskosität einer 4%igen wässrigen Lösung bei 20°C 8 mPa · s) mit
einer mittleren Teilchengrösse von ca.
5 µm.

Diese Dispersion wird mit Hilfe eines Schnellrührers ca. 20 Minuten in heftiger Bewegung gehalten.

Lösung B:
Man löst

12,0 Gt des Veresterungsproduktes aus 1 Mol
des Äthoxyäthylesters der 4,4-Bis-(4-
hydroxy-phenyl)-n-valeriansäure und
2 Mol Naphthochinon-(1,2)-diazid-(2)-5-
sulfonsäurechlorid,
30,0 Gt des in Beispiel 1 angegebenen Kresol-
Formaldehyd-Novolaks,
1,9 Gt Naphthochinon-(1,2)-diazid-(2)-4-sulfon-
säurechlorid und
0,7 Gt Kristallviolett
in einem Lösungsmittelgemisch aus
250 Gt Äthylenglykolmonomethyläther,
400 Gt Tetrahydrofuran und
100 Gt Butylacetat.

Mit dieser Streichlösung beschichtet man mit
Hilfe einer Schlitzdüse ein elektrolytisch aufgerauhtes und anodisiertes Aluminiumband. Hierbei
wird ein Schichtgewicht von 2,50 g/m² erhalten.

Beispiel 5
Dispersion A:
Man löst

20,0 Gt des in Beispiel 1 angegebenen Kresol-
Formaldehyd-Novolaks in
400,0 Gt Äthylenglykolmonomethyläther.
Nach der Filtration fügt man hierzu
0,15 Gt Aluminiumhydroxid mit einer mittleren
Teilchengrösse von 8 µm. Diese Dispersion wird mit Hilfe eines Schnellrührers
ca. 15 Minuten heftig gerührt.

Lösung B:
Man löst

12,0 Gt Bis-(5-äthyl-5-butyl-1,3-dioxan-2-yl)-
äther des 2-Äthyl-2-butyl-propan-1,3-
diols,
2,0 Gt 2-(4-Methoxy-naphth-1-yl)-4,6-bis-tri-
chlormethyl-s-triazin,
0,4 Gt Kristallviolett-Base und
20,0 Gt des in Beispiel 1 angegebenen Kresol-
Formaldehyd-Novolaks
in einem Lösungsmittelgemisch aus
200 GT Äthylenglykolmonomethyläther und
400 Gt Butylacetat.

In die Lösung B wird unter gutem Rühren die Dispersion A gegeben. Mit dieser Lösung beschichtet man ein elektrolytisch aufgerauhtes und anodisiertes Aluminiumband zu einem Trockengewicht von 2,3 g/m².

## Patentansprüche

1. Lichtempfindliche Druckplatte mit einem Schichtträger aus Aluminium und einer positiv arbeitenden lichtempfindlichen Schicht mit rauher Oberfläche und einem Gehalt an feinteiligen Partikeln, wobei die Schicht als lichtempfindliche Substanz ein 1,2-Naphthochinondiazid oder ein Gemisch einer bei Belichtung eine starke Säure bildenden Verbindung mit einer Verbindung, die mindestens eine durch Säure spaltbare C–O–C-Bindung aufweist, sowie ferner ein wasserunlösliches, in organischen Lösungsmitteln und in verdünnten wässrig-alkalischen Lösungen lösliches Harz enthält, dadurch gekennzeichnet, dass die kleinste Abmessung der Partikel mindestens so gross ist wie die Dicke der Schicht, dass der mittlere Durchmesser der Partikel zwischen 1 und 20 µm liegt und dass die lichtempfindliche Schicht 0,02 bis 2,0 Gew.-% Partikel enthält.

2. Druckplatte nach Anspruch 1, dadurch gekennzeichnet, dass die Dicke der lichtempfindlichen Schicht 0,1 bis 5 µm beträgt.

3. Druckplatte nach Anspruch 1, dadurch gekennzeichnet, dass der mittlere Durchmesser der Partikel 1 bis 15 µm grösser ist als die Dicke der Schicht.

4. Druckplatte nach Anspruch 1, dadurch gekennzeichnet, dass die Partikel aus Kieselsäure, Aluminiumoxid, Aluminiumsilikat, Aluminiumhydroxid, Titandioxid, Zinkoxid oder aus einem in dem Beschichtungslösungsmittel unlöslichen organischen Polymeren bestehen.

## Claims

1. A photosensitive printing plate comprising an aluminium support and a positive-working photosensitive layer with a rough surface and a content of finely divided particles, wherein the layer contains, as a photosensitive substance, a 1,2-naphthoquinone diazide or a mixture of a compound which forms a strong acid upon exposure and a compound which has at least one acid-cleavable C–O–C bond and, in addition to the photosensitive substance, a resin which is insoluble in water and soluble in organic solvents and in dilute aqueous alkaline solutions, characterized in that the smallest dimension of the particles corresponds at least to the thickness of the layer, that the average diameter of the particles ranges between 1 and 20 µm and that the photosensitive layer contains from 0,02 to 2.0% by weight of the finely divided particles.

2. A printing plate as claimed in claim 1, wherein the thickness of the light-sensitive layer is from 0.1 to 5 µm.

3. A printing plate as claimed in claim 1, wherein the average diameter of the particles is from 1 to 15 µm larger than the thickness of the layer.

4. A printing plate as claimed in claim 1, wherein the particles consist of silica, aluminium oxide, aluminium silicate, aluminium hydroxide, titanium dioxide, zinc oxide or of an organic polymer which is insoluble in the coating solvent.

## Revendications

1. Plaque d'impression sensible à la lumière avec un support de couche en aluminium et une couche sensible à la lumière travaillant en positif ayant une surface rugueuse et contenant des particules fines, la couche contenant comme substance sensible à la lumière un 1,2-naphtoquinone-diazide ou un mélange d'un composé formant par exposition à la lumière un acide fort avec un composé qui présente au moins une liaison C–O–C pouvant être coupée par un acide, et en outre une résine insoluble dans l'eau, soluble dans les solvants organiques et les solutions aqueuses-alcalines diluées, caractérisée en ce que la plus petite dimension des particules est au moins aussi grande que l'épaisseur de la couche, en ce que le diamètre moyen des particules est entre 1 et 20 microns et en ce que la couche sensible à la lumière contient de 0,02 à 2,0% en poids de particules.

2. Plaque d'impression suivant la revendication 1, caractérisée en ce que l'épaisseur de la couche sensible à la lumière est de 0,1 à 5 microns.

3. Plaque d'impression suivant la revendication 1, caractérisée en ce que le diamètre moyen de particules est de 1 à 15 microns plus élevé que l'épaisseur de la couche.

4. Plaque d'impression suivant la revendication 1, caractérisée en ce que les particules sont constituées d'acide silicique, d'oxyde d'aluminium, de silicate d'aluminium, d'hydroxyde d'aluminium, de bioxyde de titane, d'oxyde de zinc ou d'un polymère organique insoluble dans le solvant d'enduction.